# EUROPEAN PATENT APPLICATION

(11) **EP 1 280 280 A1**
(43) Date of publication of application: **29.01.2003**
(21) Application number: 02102040.9
(22) Date of filing: 18.07.2002
(51) Int. Cl.: H03M 13/29, H03M 13/37

(54) **Method and apparatus for reducing the average number of iterations in iterative decoding**

(30) Priority: 26.07.2001 US 915912
(71) Applicant: Texas Instruments Incorporated, Dallas, Texas 75251 (US)
(72) Inventor: JEONG, Gibong, 92128, San Diego (US); KOON, Der-Chieh, 92130, San Diego (US)
(74) Representative: Holt, Michael

(57) **Abstract**

A method and apparatus for reducing the average number of iterations in an iterative decoding technique includes the step of at the end of each decoding iteration or sub-iteration estimating the transmitted bit sequence by processing the available information. A signature for the estimation is then generated of reach iteration or sub-iteration. If this signature is the first signature generated, the decoder proceeds to the next process. When there exists a signature generated for the previous decoding iteration or sub-iteration step, the new signature for the current iteration is compared with the signature (old signature) for this previous iteration. If the two signatures match, the decoding iteration stops. Otherwise, the decoding iteration process continues.

## Description

### TECHNICAL FIELD

This invention relates in general to the field of communications and more specifically to a method and apparatus for reducing the average number of iterations in iterative decoding.

### BACKGROUND

Iterative decoding is widely used in digital communication receivers for decoding many different kinds of forward error correction codes such as turbo codes, product block codes, and low density parity check codes. The decoder tries to decode the transmitted bit sequence that is corrupted during transmission. An iterative decoder extracts information about the originally transmitted sequence in multiple iterations, each iteration generating new information based on the previous iteration result. Each decoding iteration results in additional computations and decoding delay. As the decoding iteration proceeds, the amount of newly produced information diminishes where the decoder reaches the performance limit of a forward error correction code.

There have been several techniques proposed in the art for minimizing the number of iterations, for example, A. Shibutani, et al., in an article entitled "Reducing average number of turbo decoding iterations" in Electronics Letters, vol. 35, No. 9, April 29, 1999 proposes a technique in which cyclic redundancy check bits are inserted in the encoder and transmitted together with information source bits. Although this technique helps reduce the average number of decoding iterations, it causes an increase in overhead and incurs additional transmit power or bandwidth requirements due to the need to transmit the CRC bits. Other prior art solutions to the problem require the need for integer arithmetic operations and extra memory in order to accomplish these operations.

Given the above, a method and apparatus for efficiently detecting the limit, stopping the decoding iteration and preventing any unnecessary further processing which will save computation resources and decoded is needed.

### BRIEF DESCRIPTION OF THE DRAWINGS

The features of the present invention, which are believed to be novel, are set forth with particularity in the appended claims. The invention, may best be understood by reference to the following description, taken in conjunction with the accompanying drawings, in the several figures of which like reference numerals identify like elements, and in which:
FIG. 1 shows a block diagram of a decoder in accordance with the invention.
FIG. 2 shows a flowchart highlighting the steps taken in the iterative decoding technique of the present invention.

### DETAILED DESCRIPTION OF THE PREFERRED EMBODIMENT

While the specification concludes with claims defining the features of the invention that are regarded as novel, it is believed that the invention will be better understood from a consideration of the following description in conjunction with the drawing figures, in which like reference numerals are carried forward.

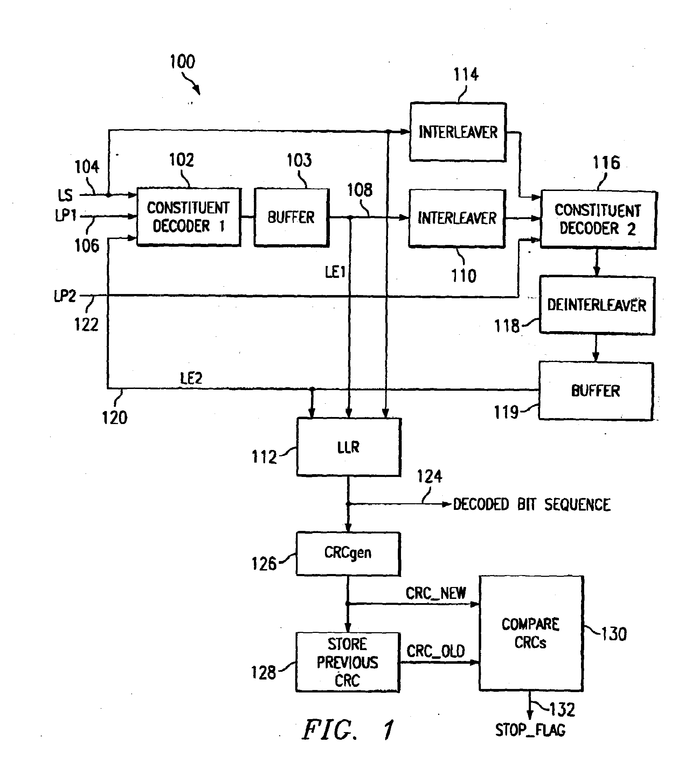

The proposed solution given by the present invention reduces the amount of computation and memory required by using a simple signature generated from the decoded sequence at each intermediate step. Referring now to FIG. 1, there is shown a block diagram of an iterative decoder, such as a turbo decoder 100. Decoder 100 is a turbo decoder that uses cyclic redundancy check (CRC) as a signature using the technique of the present invention as well be explained below. It is worth noting that the present invention is not so limited to turbo codes and can be used for other forward error correction (FEC) codes and with other types of signatures besides CRC.

Turbo decoders work by passing soft decoding information between two decoding algorithms. Each constituent decoder concentrating on one side of the encoding process, and through successive computations the two constituent decoders arrive at a consensus on the detection of the transmitted data that has been received. One constituent decoder executes and generates N new extrinsics ( *a posteriori* probabilities for the value of a given information symbol, where N is the number of data symbols), which are then applied to the other constituent decoder. This second constituent decoder executes and generates N new extrinsics, which are passed back to the first constituent decoder. This completes one iteration of the decoding process. Iterative decoding, such as turbo decoding, uses a soft-input/soft-output (SISO) constituent decoder for each component encoder. The constituent decoders take turns decoding the received data, operating on each other's incompletely decoded output. With each iteration, the estimation of the value of a received information symbol improves in accuracy.

Decoder 100 includes a first constituent decoder 102 that receives a first input signal in the form of a systematic bit (Ls) 104. A second input signal is also received at decoder 100 in the form of a parity bit 1 (Lp1) 106. The first constituent decoder 102 provides an output signal in the form of extrinsic information (Le1) 108 that is buffered by buffer 103. The Le1 output signal 108 is provided to interleaver 110 as well as a block that calculates the logarithm of likelihood ratio (LLR) 112.

The output of interleaver 110 is sent to a second constituent decoder 116 which also receives as inputs a second parity bit signal (Lp2) 122 and the output of a second interleaver 114, which interleaves the systematic bit signal 104. The output of the second constituent decoder 116 is then sent to a deinterleaver 118 which produces an output signal (Le2) 120 which is the extrinsic information from the second constituent decoder 116. The Le2 signal 120 is buffered by buffer 119. The systematic bit signal (Ls) 104, the first extrinsic information signal (Le1) 108 and the second extrinsic information signal (Le2) 120 are sent to the LLR 112 which provides as an output decoded bit sequences 124. The decoded bit sequences 124 are also sent to a CRC generator 126 which provides its output to a buffer 128 which stores the previous CRC, a comparator 130 compares the previous CRC ( crc_old) with the current CRC ( crc_new) and provides a stop_flag signal 132 when there is a match between the two. The comparator's output signal (stop_flag) causes the decoder to stop decoding since the decoder has reached its performance limit.

In accordance with the method of the present invention, at the end of each decoding iteration or sub-iteration step, the transmitted bit sequence is estimated by processing the available information. For example, in a turbo decoder such as shown in FIG. 1, this is accomplished by quantizing the sum of the newly generated extrinsic information, extrinsic information passed from the other constituent decoder(s) and channel information.

A signature such as a cyclic redundancy check (CRC) bits and check sum from the estimated bit sequence as is the case in the decoder 100 is generated. If the signature is generated for the first time, the decoder proceeds to the next process. When there exists a signature by the previous decoding iteration or sub-iteration step, the new signature (crc_new ) is compared using comparator 130 with the old signature (crc_old ). If the two signatures match, the decoding iteration process stops in response to the comparator 130 generating the stop signal (stop_flag) 130. Otherwise, the decoding iteration process continues. When the maximum number of iterations is specified and the number of iterations reaches the maximum number, the decoding iteration process also stops.

The following pseudo-C code shown in Table 1 below as well as the block diagram of FIG. 1 show an exemplary implementation for a turbo decoder using a cyclic redundancy check as a signature in accordance with the invention. However, as mentioned previously, the present invention applies to other types of forward error correction codes and sequence signatures.

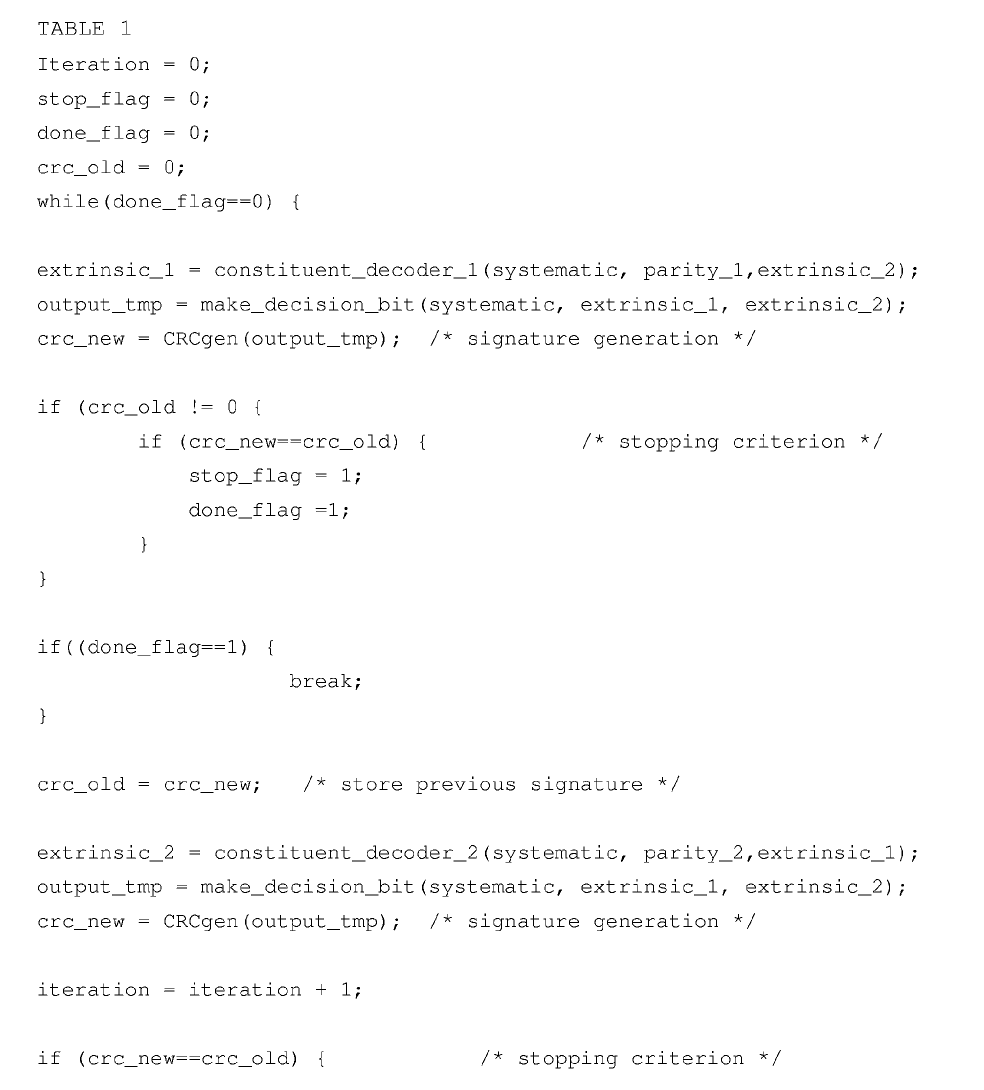

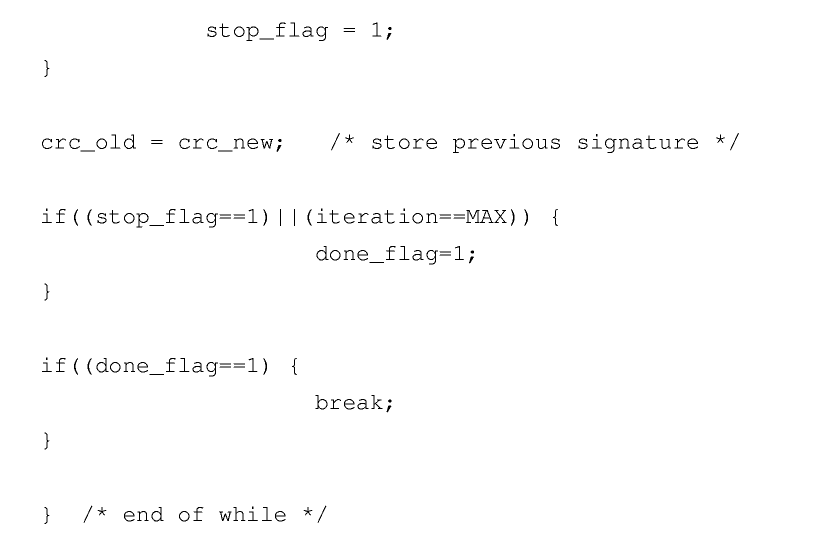

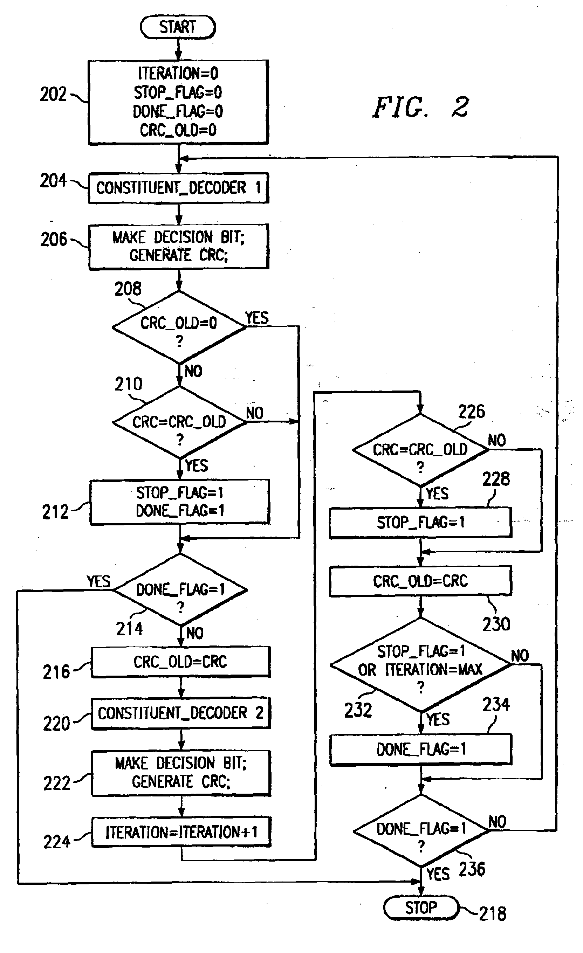

Referring now to FIG. 2, there is shown a flowchart highlighting the steps taken to reduce the decoding iterations in a decoder such as a turbo decoder in accordance with the preferred embodiment of the invention. In step 202, the different software flags (e.g., "iteration" flag is used to keep track of the number of iterations performed, "stop_flag" is the flag set when the new and old signatures match, "done_flag" is the flag that is set when either the stop_flag is set or the maximum number of iterations has been reached, and "crc_old" is a equal to the CRC signature of the previous iteration) used in the decoder of FIG. 1 are cleared. In step 204, the constituent decoder 102 performs the decoding on the incoming bits and provides the extrinsic information (Le1) 108. In step 206, a decision bit and CRC signature are generated using the hardware (e.g., LLR 112, CRC generator 126, etc.) shown in FIG. 1. In step 208, it is determined if the "crc_old" flag is equal to zero, which would mean it is the first decoding iteration. If it is the first decoding iteration, the routine moves to step 214.

In decision step 214, it is then determined if the "done_flag" is set (e.g., equal to 1). Since it is the first decoding iteration, the "done_flag" is not set, so the routine moves to step 216, where the value of "crc" is set equal to "crc_old". The routine then moves to step 220, where the second constituent decoder 116 performs the operations mention previously and in step 222, where a make decision bit and a CRC signature are generated. In step 224, the iteration counter flag ("iteration") is incremented. In decision step 226, it is determined if the CRC signature generated by the second constituent decoder is equal to the CRC signature generated by the first constituent decoder 102. If they are equal in step 228, the stop_flag is set. If the two CRC signatures are determined in step 226 not to be equal to each other, the routine moves to step 230 where the CRC signature generated by the second constituent decoder is placed in the previous signature register (stored as "crc_old").

In decision step 232, if the stop_flag is set or the maximum number of iterations or sub-iterations have been performed, then the done_flag is set in step 234, which causes the decision in step 236 to be true, and the decoding routine stops in step 218. If however, the done_flag is not set, the decoding routine moves back to step 204, where the decoding routine continues, until the previous and current signatures are determined to be equal, at which point the done_flag will be set and the decoding routine is stopped.

As been shown above, the present invention provides a simple technique for efficiently detecting the performance limit of a forward error correction code and stopping the decoding iteration and preventing further processing. This will decrease decoding time and conserve power.

While the preferred embodiments of the invention have been illustrated and described, it will be clear that the invention is not so limited. Numerous modifications, changes, variations, substitutions and equivalents will occur to those skilled in the art without departing from the spirit and scope of the present invention as defined by the appended claims. The present invention provides for a method and apparatus for minimizing the iterations in an iterative decoder without the need for increasing the transmission overhead or requiring excessive computations or memory.

## Claims

1. A method for reducing the average number of iterations in an iterative decoder, comprising the steps of:
(a) estimating a bit sequence received by the iterative decoder;
(b) generating a signature from the estimated bit sequence;
(c) repeating steps (a) and (b) at least once in order have generated first and second signatures;
(d) comparing the first and second signatures; and
(e) stopping the iterative decoder from continuing to decode if in step (d) the first and second signatures match.

2. A method as defined in claim 1, further comprising the step of:
(f) allowing the iterative decoder to continue to decode if in step (d) the first and second signatures do not match.

3. A method as defined in claim 1 or claim 2, wherein in step (b) the signature generated comprises cyclic redundancy check (CRC) bits.

4. A method as defined in any preceding claim, wherein the iterative decoder comprises a turbo decoder.

5. A method as defined in any preceding claim, comprising the following step:
(g) stopping the iterative decoder from continuing to decode if a predetermined number of decoding iterations have been performed.

6. A method as defined in any preceding claim, comprising the further steps of:
(g) repeating steps (a) and (b) until two successive signatures match or a predetermined number of decoding iterations have been performed.

7. An iterative decoder, comprising:
first and second constituent decoders each having an input and an output, each of the first and second constituent decoders receiving an input signal at its input and generating an estimation signal after each decoding iteration;
a signature generator coupled to the outputs of the first and
second constituent decoders for generating a signature after each of the decoding iterations; and
a comparator for comparing two successive signatures generated by the signature generator and providing a signal if the two successive signatures match that informs the iterative decoder to stop decoding.

8. An iterative decoder as defined in claim 7, wherein the iterative decoder comprises a turbo decoder.

9. An iterative decoder as defined in claim 7 or claim 8, wherein the signature generator generates a signature in the form of cyclic redundancy check (CRC) bits.
